# EUROPEAN PATENT SPECIFICATION

(11) **EP 0 871 351 B1**
(45) Date of publication and mention of the grant of the patent: **18.08.2004**
(21) Application number: 96942659.2
(22) Date of filing: 24.12.1996
(51) Int. Cl.: H05K 1/18, H01R 4/02, H01R 12/32

(54) **FEMALE TERMINAL**
ANSCHLUSSBUCHSE
RACCORD TERMINAL FEMELLE

(30) Priority: 28.12.1995 JP 35324795
(43) Date of publication of application: 14.10.1998
(73) Proprietor: KABUSHIKI KAISHA TOKAI-RIKA-DENKI-SEISAKUSHO, Niwa-gun, Aichi-ken 480-01 (JP)
(72) Inventor: HIGUCHI, M.-Kabushiki Kaisha Tokai-Rika-Denki-Sa., Aichi-ken 480-01 (JP); MIZUTANI, T.-Kabushiki Kaisha Tokai-Rika-Denki-S., Aichi-ken 480-01 (JP); IMAEDA, S. -Kabushiki Kaisha Tokai-Rika-Denki-Sa., Aichi-ken 480-01 (JP); MIYAKE, Y. -Kabushiki Kaisha Tokai-Rika-Denki-Sa., Aichi-ken 480-01 (JP); NIWA, T. -Kabushiki Kaisha Tokai-Rika-Denki-Sais., Aichi-ken 480-01 (JP); SHIMURA, H. -Kabushiki Kaisha Tokai-Rika-Denki-S., Aichi-ken 480-01 (JP)
(74) Representative: Grünecker, Kinkeldey, Stockmair & Schwanhäusser Anwaltssozietät
(86) International application number: PCT/JP1996/003827
(87) International publication number: WO 1997/024910

(56) References cited:
- WO-A-99/23723
- DE-U- 29 500 591
- JP-A- 1 029 793
- JP-A- 2 005 497
- JP-U- 1 060 573

## Description

### TECHNICAL FIELD

This invention relates to an improvement of a female terminal.

### BACKGROUND ART

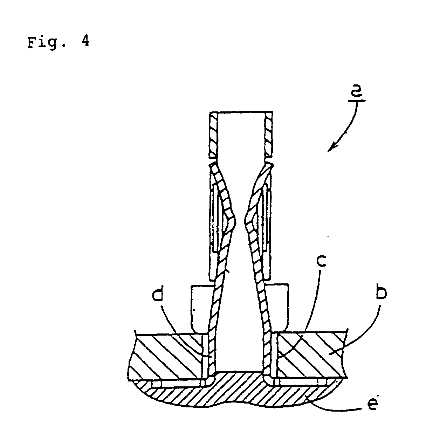

When, in order to secure a female terminal a to a mounting (inserting) hole c formed in a printed wiring board b, the board 11 is dipped in a molten solder with a male-terminal inserting cylindrical portion d suitably locked, sometimes as shown in FIG. 4 the molten solder e on the edge of the mounting hole spreads to close the cylindrical portion d in a bridge-like form, and solidifies.

DE 295 00 591 U discloses a female terminal which includes a cylindrical portion for inserting a male terminal. Cable lugs extend from said cylindrical portion. An end part of said cylindrical portion has a pair of notched recesses which are confronted with each.

In view of the foregoing, an object of the invention is to provide a female terminal which is so designed in structure that the molten terminals will never close the male-terminal inserting cylindrical portion.

### DISCLOSURE OF THE INVENTION

The foregoing object of the invention has been achieved by the provision of a female terminal according to ctaim 1.

The above-described female terminal has at least a pair of notched recesses. Therefore, the molten solder 21, which otherwise spreads in a bridge-like form to close the cylindrical portion, is lowered in conformability; that is, its sticking force is decreased, so that it is dropped from the notched recesses. The remaining molten solder on the cylindrical portion is shifted towards the edges of the cylindrical portion except for the notched recesses by the surface tension thereof, and solidified. Therefore, the cylindrical portion, into which the male terminal is to be inserted, is not closed by the solder, yet the female terminal is fixedly mounted on the printed wiring board. This feature contributes to the improvement of productivity.

### BRIEF DESCRIPTION OF THE DRAWINGS

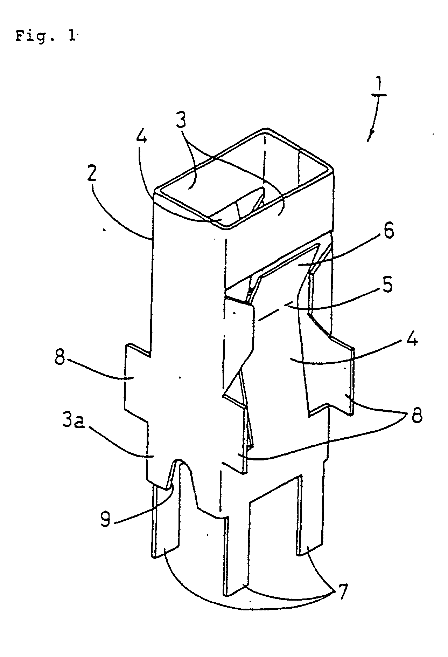

FIG. 1 is a perspective view of a female terminal 1, which constitutes a preferred embodiment of the invention.
FIG. 1 is a sectional view showing the female terminal 1 which is mounted on a printed wiring board.
FIG. 3 is a perspective view of a cylindrical portion of one modification of the female terminal of the invention.
FIG. 4 is a sectional view of a conventional female terminal.

### PREFERRED EMBODIMENT OF THE INVENTION

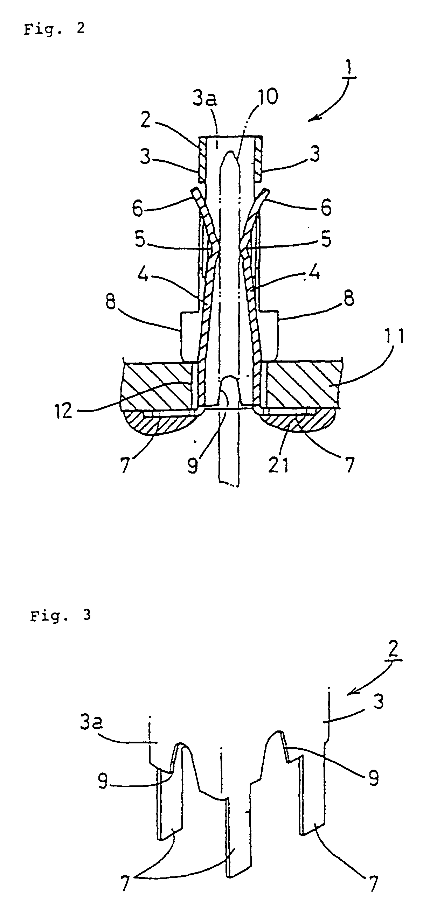

A female terminal, a preferred embodiment of the invention, will be described with reference to the accompanying drawings. FIG. 1 is a perspective view of the female terminal 1 according to the invention; FIG. 2 is a sectional view showing the female terminal 1 which is mounted on a printed wiring board; FIG. 3 is a perspective view of a cylindrical portion of one modification of the female terminal of the invention; and FIG. 4 is a sectional view of a conventional female terminal. The female terminal 1 is formed on a progressive press machine. That is, a conductive metal hoop material is punched into a part in a predetermined form, and the part thus obtained is bent. This bending work forms a vertically elongated cylindrical portion 2, into which a male terminal 10 is inserted.

The side surfaces 3 and 3 which are extended longitudinally in such a manner as to confront with each other, have clamping elastic pieces 4 and 4, respectively. The clamping elastic pieces 4 and 4 are formed as follows: That is, the clamping elastic pieces 4 and 4 have clamping portions 5 and 5 at the middle, and end portions 6 and 6 extended upwardly from the clamping portions 5 and 5. The clamping elastic pieces 4 and 4 are bent towards each other in such a manner that the distance between the clamping elastic pieces 4 and 4 are gradually smaller towards the clamping portions 5; i.e., it is smallest at their clamping portions 5 and 5, and the end portions 6 and 6 are inclined outwardly. A pair of side surfaces 3 and 3 of the cylindrical portion 2 which are confronted with each other, have two pairs of locking legs 7 (four locking legs 7) extended from their edges, respectively, in such a manner that they are confronted with each other. The remaining side surfaces 3a and 3a of the cylindrical portion have a pair of wing-shaped pieces 8 and 8, respectively, at a level corresponding to the thickness of a printed wiring board 11 (described later). In addition, the side surfaces 3a and 3a have notched recesses 9 and 9 in their lower end portions, respectively, in such a manner that the recesses 9 and 9 are confronted with each other.

The above-described female terminal 1 is installed as follows: The lower end of the cylindrical portion is inserted into a mounting hole 12 formed in the printed wiring board 11 until the lower ends of the wing-shaped pieces 8 are abutted against the edge portion of the mounting hole 12. Under this condition, the locking legs 7 which are protruded from the rear surface of the printed wiring board 11, are bent horizontally, to lock the female terminal 1. Under this condition, the rear surface of the printed wiring board 11 is dipped in a molten solder 21. In this operation, the molten solder sticks onto the locking legs 7 and spreads into the lower part of the cylindrical portion 2, thus closing the lower opening of the cylindrical portion 2 in a bridge-like form. The parts other than the mounting hole which need no soldering process has been subjected to solder resist printing.

Thereafter, the printed wiring board 11 is pulled up from the molten solder 21. In this operation, since the cylindrical portion has the notched recesses 9, the molten solder 21 with respect to the cylindrical portion 2 is lowered in conformability; that is, its sticking force is decreased, so that it is dropped from the notched recesses 9. The remaining molten solder 21 on the cylindrical portion 2 is shifted towards the edges of the cylindrical portion 2 except for the notched recesses 9 and 9 by the surface tension thereof, and solidified. Therefore, the cylindrical portion 2, into which the male terminal 10 is to be inserted, is not closed by the solder, yet the female terminal 11 is fixedly mounted on the printed wiring board 11. This feature contributes to the improvement of productivity.

In addition, the same notched recess 9 may be formed between the locking legs 7 of the side surfaces 3 and 3.

## Claims

1. A female terminal adapted to be inserted in a mounting hole (12) formed in a printed wiring board (11) wherein
said female terminal (1) includes a cylindrical portion (2) for inserting a male terminal (10) passing through said printed wiring board (11);
locking legs (7) extending from said cylindrical portion (2) are adapted to be bent horizontally for fixing said female terminal (1) to said mounting hole (12) of said printed wiring board (11); and
an end part of said cylindrical portion (2) has at least a pair of notched recesses (9) which are confronted with each other, said notched recesses (9) preventing the cylindrical portion (2) to be closed by solder during soldering of the female terminal (1) with the printed wiring board (11).

## Patentansprüche

1. Buchsenanschluss, der zum Einsetzen in ein Montageloch (12) eingerichtet ist, das in einer Leiterplatte (11) ausgebildet ist, wobei
der Buchsenanschluss (1) einen zylindrischen Bereich (2) zum Einsetzen eines Steckeranschlusses (10) enthält, der durch die Leiterplatte (11) hindurchtritt;
Verriegelungsbeine (7), die sich von dem zylindrischen Bereich (2) erstrecken, sind dazu eingerichtet, horizontal zum Befestigen des Buchsenanschlusses (1) in dem Montageloch (12) der Leiterplatte (11) horizontal gebogen zu werden; und
ein Endteil des zylindrischen Bereichs (2) wenigstens ein Paar ausgeklinkter Aussparungen (9) aufweist, die einander gegenüberstehen, wobei die ausgeklinkten Aussparungen (9) verhindern, dass der zylindrische Bereich (2) durch Lötmittel während des Verlötens des Buchsenanschlusses (1) mit der Leiterplatte (11) verschlossen wird.

## Revendications

1. Raccord terminal femelle adapté pour être inséré dans un trou de montage (12) formé dans un tableau de câblage imprimé (11), dans lequel :
ledit raccord terminal femelle (1) comprend une partie cylindrique (2) pour insérer un raccord terminal mâle (10) passant par ledit tableau de câblage imprimé (11) ;
des pattes de verrouillage (7) s'étendant à partir de ladite partie cylindrique (2) sont adaptées pour être fléchies horizontalement afin de fixer ledit raccord terminal femelle (1) sur ledit trou de montage (12) dudit tableau de câble imprimé (11) ; et
une partie d'extrémité de ladite partie cylindrique (2) a au moins une paire d'enfoncements crantés (9) qui sont orientés l'un en face de l'autre, lesdits enfoncements crantés (9) empêchant la fermeture de la partie cylindrique (2) par soudage pendant le soudage du raccord terminal femelle (1) avec le tableau de câblage imprimé (11).
